# EUROPÄISCHE PATENTSCHRIFT

(11) **EP 1 097 615 B1**
(45) Veröffentlichungstag und Bekanntmachung des Hinweises auf die Patenterteilung: **17.09.2003**
(21) Anmeldenummer: 99961990.1
(22) Anmeldetag: 05.07.1999
(51) Int. Cl.: H05K 3/02

(54) **VERFAHREN ZUR VERBINDUNG VON KUPFERFOLIEN UND TRENNBLECHEN**
METHOD FOR JOINING COPPER FILMS AND SEPARATING SHEETS OF METAL
PROCEDE DE LIAISON DE FILMS EN CUIVRE ET DE TOLES DE SEPARATION

(30) Priorität: 14.07.1998 DE 19831461
(43) Veröffentlichungstag der Anmeldung: 09.05.2001
(60) Teilanmeldung: 03014931.4
(73) Patentinhaber: Backhaus, Dieter, 79350 Sexau (DE)
(72) Erfinder: Backhaus, Dieter, 79350 Sexau (DE)
(74) Vertreter: Hübsch, Dirk, Dipl.-Ing.
(86) Internationale Anmeldenummer: DE9902122
(87) Internationale Veröffentlichungsnummer: WO00004749

(56) Entgegenhaltungen:
- WO-A-97/25841
- DE-A- 2 425 778

## Beschreibung

Die Erfindung betrifft ein Verfahren zur Verbindung von Kupferfolien und Trennblechen für die Verpressung von mehrlagigen Leiterplatten.

Bekannt ist, daß die beiden Außenlagen einer mehrlagigen Leiterplatte mit ganzflächigen Kupferfolien ausgerüstet sind, die beim Laminiervorgang mit Hilfe der darunterliegenden Prepreg-Schicht (ein mit Epoxydharz getränktes Glasfasergewebe) auf das jeweilige Paket auflaminiert werden. Aus diesen Folien wird dann das Endleiterbild geätzt. Die Kupferfolie muß dabei frei von Eindrücken, Kratzern oder Erhebungen sein. Diese Gleichmäßigkeit erreicht man, wenn Trennbleche mit einer glatten Oberfläche eingesetzt werden. So können auch mehrere Lagen gleichzeitig verpreßt werden.

Die Verpressung der Leiterplatten erfolgt in Etagen- oder Vakuumpressen, wobei die Kupferfolie unter Druck und Erhitzung auf ca. 180 Grad Celsius mit dem Prepreg verpreßt wird und anschließend mit dem Paket der Innenlagen einen untrennbaren Verbund bildet.

Nach DE 38 44 498 A1 soll ein Verzug der verpreßten Multilayerpakete und damit eine unebene Kupferoberfläche dadurch vermieden werden, daß das Verpressen durch Vakuumanwendung und isostatische Preßtechnik erfolgt. Dabei werden zusätzliche Platten, schwimmend gelagert und thermisch isoliert, eingeführt, die bei der Erwärmung des Multilayerpaketes die Preßplatten kühl halten.

Nachteil dieses Verfahrens ist es, daß sich auf jeder Werkzeugplatte ein Paket gleicher Fläche und Dicke befinden muß, so daß das bei der Erhitzung austretende Epoxydharz die Kanten des Multilayers verkleben kann.

Nach DE 3507 568 C2 soll zwar ein Verrutschen der Prepreg-Lagen durch eine Rutschsicherung vermieden werden, was einen möglichen Austritt des Prepregs an den Paketseiten jedoch nur dann verhindern kann, wenn die Kupferfolien etwas größer als die anderen Lagen gewählt werden, so daß das Prepreg daran ablaufen kann. Nachteil hierbei ist, daß Edelstahl die Wärme schlecht leitet, weshalb eine längere Erwärmungszeit nötig ist. Auch ist die Wärmedurchdringung ungleichmäßiger als z.B. bei Aluminiumblechen.

Das Verfahren nach DE 41 16 543 A1 verwendet ein Stahltrennblech mit einem auf 16 10 6 pro Grad Celsius erhöhten Wärmeausdehnungskoeffizienten, der dadurch dem Ausdehnungskoeffizienten des Kupfers angenähert ist. Hierdurch wird zwar eine Oberflächenspannung weitestgehend vermieden, die Erwärmungszeit für das Edelstahlblech bleibt jedoch gleich hoch.

Immer häufiger werden deshalb statt Stahl- Aluminiumbleche verwendet, die die Wärme besser und gleichmäßiger leiten können.

Weiterhin müssen bei allen oben genannten Verfahren die Kupferfolie und das entsprechende Trennblech mit den anderen Lagen in einem Legeraum durch speziell geschultes Personal von Hand zu einem Paket zusammengefügt werden (vgl. Manfred Huschka, 3Einführung in die Multilayer-Preßtechnik" Eugen G. Leuze Verlag, 1988, Kapitel 3). Die oft sehr dünnen und daher empfindlichen Kupferfolien können dabei schnell zerdrückt werden.

Das Verfahren nach DE 3131688 A1 beschreibt lediglich die Herstellung eines Aluminiumblech-Kupferverbundes. Ein separates Handhaben von Kupferfolien wird darin jedoch nicht angesprochen..

Bei dem nachfolgenden Laminiervorgang besteht weiterhin die Gefahr, daß aufgrund der Verklebung, wegen des unterschiedlichen Wärmeausdehnungskoeffizienten von Kupfer und Aluminium größere Oberflächenspannungen entstehen. Aluminium dehnt sich schon sehr viel früher aus, als das Kupfer. Zudem kann es auch hier nach Auflösung des Epoxydharzes zu Verklebungen an den Rändern des Paketes kommen.

Auch das Verfahren nach dem U.S Patent 5.160.567 befaßt sich mit der Herstellung von Laminaten. Dabei werden die Preßbleche beidseitig mit überstehender Kupferfolie belegt, wobei die Kupferfolien dann im Randbereich des Preßbleches miteinander verbunden werden.

Nachteilig wirkt sich hierbei die Verwendung des Edelstahlbleches aus, da die Wärme schlechter geleitet wird, als bei Aluminiumblechen und somit länger erwärmt werden muß. Zudem muß auch hier die Kupferfolie separat aufgelegt werden, was bei entsprechend dünner Folie nur schwer ohne Verdrückungen möglich ist.

Der Erfindung liegt daher die Aufgabe zugrunde, ein Verfahren zu entwickeln, daß sowohl eine Verklebung von Preßlagen als auch eine Deformierung der Kupferfolie in verschiedenen Arbeitsgängen verhindert bzw. weitestgehend vermeidet.

Diese Aufgabe wird erfindungsgemäß durch die Merkmale des Patentanspruches 1 gelöst.

Durch diese Maßnahme wird erreicht, daß beim Legen des Preßpaketes die Kupferfolie nicht mehr separat angefaßt und eventuell dabei verknickt wird. Die Folie bleibt flach über das Blech gespannt, weswegen auch sehr dünne Kupferfolien gewählt werden können. Wenn direkt nach dem Einfassen Positionslöcher eingestanzt werden, so wird damit vermieden, daß bei einem weiteren Arbeitsgang, nämlich Stanzen der Positionslöcher, Verschiebungen und Beschädigungen an der Kupferfolie entstehen können.

Für die Vorbereitung des Multilayer-Preßvorganges muß dann nur noch in einem Arbeitsgang das mit den Kupferfolien bespannte und mit Registrierlöchern versehene Aluminiumblech auf das Prepreg gelegt werden.

Während des Preßvorganges kann sich das Aluminiumblech ungehindert ausdehnen und unter Umständen die Kupferfolienverbindung durchbrechen, ohne Oberflächenspannungen auf dem Kupfer hervorzurufen. Sobald das Epoxydharz unter dem Kupfer auseinanderfließt, kann es an der überstehenden Kupferfolie entlanglaufen, ohne mit dem Aluminiumblech in Verbindung zu geraten.

Der überstehende Rand der Kupferfolien mit den Kleberesten kann dann am Rand des Aluminiumbleches und damit außerhalb der Nutzfläche abgetrennt werden.

Eine mechanische Verbindung der Kupferfolien, z.B. durch Verstanzen oder Prägen, ermöglicht dabei eine ungehinderte Ausdehnung des Bleches, so daß sich das austretende Harz besser verteilen kann, weil auf der Fläche keine Spannungen mehr bestehen.

Eine Verklebung des überstehenden Kupferrandes sichert über längere Zeit die Verbindung, so daß die mit Kupfer überspannten Trennbleche über einen größeren Zeitraum gelagert werden können.

Eine thermische Verbindung der Kupferfolien, wie z.B. Löten oder Schweißen ermöglicht ebenfalls die ungehinderte Ausdehnung des Bleches. Welche Form der Verbindung gewählt wird, hängt entscheidend von den Kosten dafür ab.

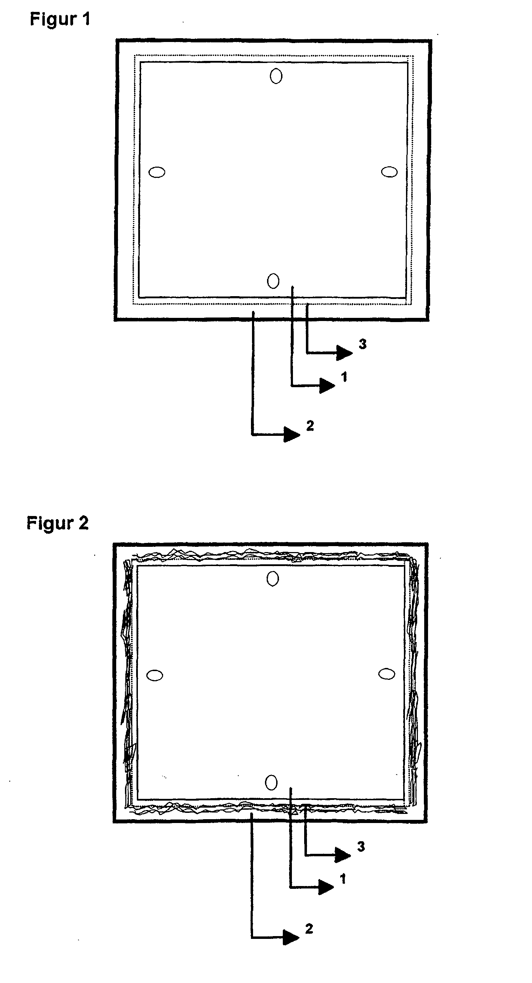

Anhand der Figuren 1 und 2 wird das Ausführungsbeispiel näher erläutert.

Die Figur 1 zeigt ein mit Positionslöchern versehenes (Aluminium-)Trennblech einer bestimmten Größe **1,** welches von beiden Seiten mit einer größer gewählten Kupferfolie bedeckt ist **2**. Die Verbindung der Kupferfolien erfolgt dann an einer Stelle außerhalb der Fläche des Trennbleches, so daß aber noch etwas Kupferfolie übersteht **3**.

Bei Figur 2 ist das mit den Kupferfolien beidseitig bespannte Trennblech nach der Verpressung zu sehen. Das ausgedehnte Aluminiumblech hat die Verbindung durchbrochen **1**. Die Kupferfolie darunter ist im Bereich der Nutzenfläche glatt mit den Innenlagen verpreßt **2**. Das ausgelaufene Epoxydharz klebt an dem überstehenden Rand der Kupferfolie **3**.

Es handelt sich insoweit um einen neuen Verbundwerkstoff, der den Eigenschaften der einzelnen Komponenten, bessere Wärmeleitfähigkeit und stark abweichende Wärmeausdehnungskoeffizienten Rechnung trägt.

## Patentansprüche

1. Verfahren zur partiellen Verbindung von Kupferfolien beliebiger Art und Dicke mit Aluminium-Preßblechen beliebiger Legierung und Dicke, die beim Laminieren von Mehrlagenleiterplatten-Preßpaketen vorgesehen werden, durch
- beidseitiges Auflegen der Kupferfolien auf das Al-Preßblech, wobei die Abmessungen der Kupferfolien größer als die des Preßbleches sind, sodaß diese allseitig über das Preßblech hinausragen und eng an diesem anliegen und
- stoffschlüssiges Verbinden der überstehenden Kupferfolien mit gleichzeitigen Einbringen der Registrierlöcher derart, daß zwischen dem Al-Preßblech und den Verbindungsstellen ein Freiraum - zur Aufnahme der thermisch bedingten Ausdehnung des Preßbleches - verbleibt.

2. Verfahren nach Anspruch 1, **dadurch gekennzeichnet, daß** die Kupferfolien miteinander verklebt sind.

3. Verfahren nach Anspruch 1, **dadurch gekennzeichnet, daß** die Kupferfolien durch Löten oder Schweißen miteinander verbunden sind.

## Claims

1. Method for partially connecting copper foils of any given type and thickness with aluminum separators of any given alloy and thickness, as to be used in laminating multilayers, by
- placing a copper foil panel on both sides of the aluminum separator, whereby the copper foil panels are larger than the aluminum separator so that they project beyond the separator on all sides and lie flat on it, and
- fixing the oversize/projecting copper foil panels to each other with simultaneous punching of registration slots in such a manner that there is a free space between the fixation points and the aluminium separator to allow the separator to expand.

2. Method according to claim 1, **characterized in that** the copper foil panels are joined together with glue.

3. Method according to claim 1, **characterized in that** the copper foil panels are joined together by soldering or welding.

## Revendications

1. Procédé pour lier partiellement des feuilles de cuivre de type et d'épaisseur quelconques à des tôles à presser en aluminium, en alliage quelconque et d'épaisseur quelconque, utilisées pour le placage de paquets de plaquettes à circuit imprimé multicouches, selon lequel
• les feuilles de cuivre sont appliquées sur les deux faces de la tôle à presser en aluminium, les dimensions des feuilles de cuivre étant supérieures à celles de la tôle à presser en aluminium, de sorte que lesdites feuilles dépassent de tous les côtés par rapport à la tôle à presser en aluminium et sont étroitement appliquées sur celle-ci et
• les feuilles de cuivre dépassantes sont liées l'une à l'autre par matière en même temps que sont réalisés les trous de positionnement, de telle sorte qu'il subsiste entre la tôle d'aluminium emboutie et les points de liaison un espace libre autorisant la dilatation thermique de la tôle emboutie.

2. Procédé selon la revendication 1, **caractérisé en ce que** les feuilles de cuivre sont collées entre elles.

3. Procédé selon la revendication 1, **caractérisé en ce que** les feuilles de cuivre sont liées entre elles par brasure ou par soudure.
